# EUROPEAN PATENT APPLICATION

(11) **EP 3 799 050 A1**
(43) Date of publication of application: **31.03.2021**
(21) Application number: 20179494.8
(22) Date of filing: 11.06.2020
(51) Int. Cl.: G11C 13/00, G11C 11/16

(54) **TECHNIQUES TO GENERATE & ADJUST PROGRAM CURRENT PULSES FOR CROSS-POINT NONVOLATILE MEMORY**

(30) Priority: 25.09.2019 US 201916583157
(71) Applicant: Intel Corporation, Santa Clara, CA 95054 (US)
(72) Inventor: ARENDT, Kevin, Orangevale, CA 95662 (US); CHU, Daniel, Folsom, CA 95630 (US); DUNCAN, Daniel, Santa Clara, CA 95054 (US)
(74) Representative: Goddar, Heinz J.

(57) **Abstract**

A program current pulse (e.g., reset or set pulse) for a cross-point memory cell can be generated with improved efficiency and effectiveness by controlling the voltage applied to a selection transistor near the memory cell to increase current through the memory cell. In one example, a method involves applying a first voltage to a gate of a selection transistor coupled between the memory cell and a first supply voltage and transitioning the first voltage applied to the gate of the selection transistor to a second voltage. The transition from the first voltage to the second voltage causes an increase of current through the memory cell due to a charge sharing event between capacitances at the terminals of the selection transistor. The current path through the memory cell can then be disabled to terminate the program current pulse. The timing and magnitude of the control signals can be controlled to achieve the desired current pulse width and amplitude.

## Description

### FIELD

The descriptions are generally related to memory, and more particularly, to techniques to generate program current pulses for nonvolatile memory, such as cross-point memory.

### BACKGROUND

Memory resources have innumerable applications in electronic devices and other computing environments. There is demand for memory technologies that can scale smaller than traditional memory devices. However, continued drive to smaller and more energy efficient devices has resulted in scaling issues with traditional memory devices. Three-dimensional memory devices emerged as a solution to the scaling limitations of traditional memory devices.

### BRIEF DESCRIPTION OF THE DRAWINGS

The following description includes discussion of figures having illustrations given by way of example of implementations of embodiments of the invention. The drawings should be understood by way of example, and not by way of limitation. As used herein, references to one or more "embodiments" are to be understood as describing at least one implementation of the invention that includes one or more particular features, structures, or characteristics. Thus, phrases such as "in one embodiment" or "in an alternate embodiment" appearing herein describe various embodiments and implementations of the invention, and do not necessarily all refer to the same embodiment. However, they are also not necessarily mutually exclusive.
**Figure 1** is an example of a memory cell that can be programmed using techniques described herein.
**Figure 2** illustrates an example of a portion of a memory cell array.
**Figure 3A** illustrates an example of a circuit topology of a selected cross-point memory cell.
**Figures 3B-3D** illustrate examples of circuit topologies of a cross-point memory cells in which a program current pulse can be generated by controlling the gate voltage of a selection transistor.
**Figure 4** is an example of a reset operation waveform of a selected memory cell.
**Figure 5** is a flow chart of an example of a method for generating a program current pulse in a cross-point memory cell.
**Figure 6** is a block diagram of a system that can include a non-volatile memory device
**Figure 7** provides an exemplary depiction of a computing system.

Descriptions of certain details and implementations follow, including a description of the figures, which may depict some or all of the embodiments described below, as well as discussing other potential embodiments or implementations of the inventive concepts presented herein.

### DETAILED DESCRIPTION

Techniques for generating program current pulses for non-volatile memory are described herein.

Programming operations for cross-point memory cells typically include "set" and "reset" operations. In one example, set and reset operations cause a memory cell to transition between one of multiple stable states. For example, a set operation for a phase change memory cell can be defined as causing the phase change material to transition from an amorphous state to a crystalline state. In one such example, a reset operation can be defined as causing a transition from a crystalline to an amorphous state. Other examples may define set and reset operations differently (e.g., a set operation can be defined as causing a transition from an amorphous to a crystalline state).

Set and reset operations typically involve the generation and application of current pulses to the memory cells. The current pulses to perform set and reset operations are controlled for amplitude of current and time or the width of the pulses. Typically, a current pulse to perform a reset operation is relatively narrow and has a high amplitude. In contrast, a current pulse to perform a set operation is wider and has a lower amplitude. Resetting a memory cell including a chalcogenide phase change material typically requires a large current to melt the material. Conventional cross-point memory devices perform set and reset operations with dedicated current mirror circuits to generate current pulses with the desired current amplitude. The current mirror circuits may be sufficient to generate a wide, low amplitude current pulse to perform a set operation. However, current mirror circuits are often unable to produce a sufficiently narrow and high amplitude current pulse to reset a memory cell. There is typically significant resistance and parasitic capacitance in the path from the current mirrors to the memory cells that limit the edge rate that can be achieved with a current mirror.

In contrast to conventional memory circuit architecture, after selection of a memory cell is achieved, a program current pulse can be generated and adjusted by controlling the gate voltage of a selection transistor without a program (e.g., set or reset) current mirror circuit. By controlling the gate voltage of a word line or bit line selection transistor, the voltage at the word line or bit line can be quickly changed due to charge sharing between capacitance at the source and drain terminals of the transistor. The change in the wordline or bitline voltage will increase the bias across the cell. The quick change in voltage causes the current through the memory cell to increase, causing the rising edge of the programming pulse. The current path through the memory cell can then be disabled, causing the falling edge of the programming pulse. By generating the programming pulse with the selection transistor and inherent capacitances near the memory cell, a much narrower pulse with faster rise and fall times can be generated than by dedicated circuitry further from the memory cell. Additionally, generating programming pulses without dedicated current mirrors enables reduction of the die size. Although the examples in this disclosure refer primarily to reset current pulses, the techniques described herein can also be used to generate and control any programming current pulses, including set current pulses, setback current pulses (e.g., in a read operation to mitigate the disturb effect of snapback discharge), or other program current pulses.

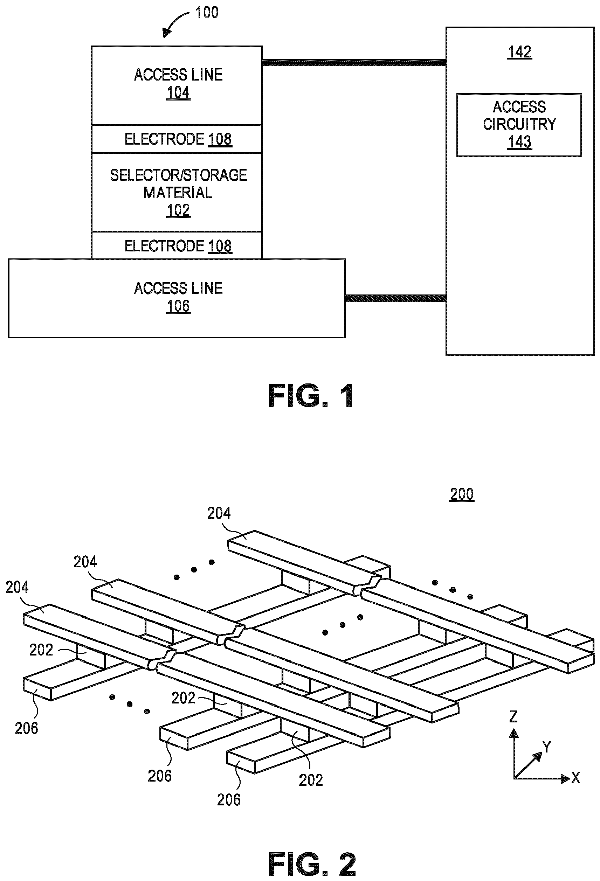

**Figure 1** is an example of a memory cell that can be programmed using techniques described herein.

Figure 1 illustrates a memory cell 100. The memory cell 100 includes one or more layers of material 102 to store data and aid in selection of the memory cell 100. For example, the memory cell 100 can include a storage material 102, a selector material, or both, between access lines 104 and 106. In one example, the memory cell includes a layer of storage material and a separate layer of selector material. In one example, the memory cell 100 includes a self-selecting material that exhibits both memory and selection effects. A self-selecting material is a storage material that enables selection of a memory cell in an array without requiring a separate layer of material for selection of the cell. In one example, a self-selecting memory cell includes a single layer of material that acts as both a selector element to select the memory cell and a memory element to store a logic state. A material exhibits memory effects if the material can be put in one of multiple stable states (e.g., via a write operation), and subsequently read back (e.g., via a read operation).

The storage material can include one or more of: tellurium (Te), selenium (Se), germanium (Ge), antimony (Sb), bismuth (Bi), lead (Pb), tin (Sn), indium (In), silver (Ag), arsenic (As), sulfur (S), phosphorus (P), molybdenum (Mo), gallium (Ga), aluminum (Al), oxygen (O), nitrogen (N), chromium (Cr), gold (Au), niobium (Nb), palladium (Pd), cobalt (Co), vanadium (V), nickel (Ni), platinum (Pt), titanium (Ti), tungsten (W), tantalum (Ta) or other materials. For example, the storage material may include one or more chalcogenide materials such as such as Te-Se, Ge-Te, In-Se, Sb-Te, Ge-Sb, Ta-Sb-Te, Ga-Sb, In-Sb, As-Te, As-Se, Al-Te, As-Se-Te, Ge-Sb-Te, Ge-As-Se, Te-Ge-As, V-Sb-Se, Nb-Sb-Se, In-Sb-Te, In-Se-Te, Te-Sn-Se, V-Sb-Te, Se-Te-Sn, Ge-Se-Ga, Mo-Sb-Se, Cr-Sb-Se, Ta-Sb-Se, Bi-Se-Sb, Mo-Sb-Te, Ge-Bi-Te, W-Sb-Se, Ga-Se-Te, Ge-Te-Se, Cr-Sb-Te, Sn-Sb-Te, W-Sb-Te, Sn-Sb-Bi, In-Sb-Ge, As-Sb-Te, Ge-Te-Ti, Te-Ge-Sb-S, Te-Ge-Sn-O, Te-Ge-Sn-Au, Pd-Te-Ge-Sn, In-Se-Ti-Co, Ge-Sb-Te-Pd, Ge-Sb-Te-Co, Sb-Te-Bi-Se, Ag-In-Sb-Te, Ge-Se-Te-In, As-Ge-Sb-Te, Se-As-Ge-In, Ge-Sb-Se-Te, Ge-Sn-Sb-Te, Ge-Te-Sn-Ni, Ge-Te-Sn-Pd, and Ge-Te-Sn-Pt, Si-Ge-As-Se, In-Sn-Sb-Te, Ge-Se-Te-Si, Si-Te-As-Ge, Ag-In-Sb-Te, Ge-Se-Te-In-Si, Se-As-Ge-Si-In, or other materials capable of being programmed to one of multiple states. One or more elements in a chalcogenide material may be dopants. For example, the storage material may include dopants such as: aluminum (Al), oxygen (O), nitrogen (N), silicon (Si), carbon (C), boron (B), zirconium (Zr), hafnium (Hf), or a combination thereof. The storage material may include other materials or dopants not explicitly listed.

As mentioned above, some memory cells include a separate layer of selector material to form a selector device. The selector material may include a chalcogenide material (typically a chalcogenide glass) or other material capable of operating as a selection element. In one example, the selector material includes one or more of: silicon (Si), germanium (Ge), selenium (Se), arsenic, tellurium (Te), or other materials. In one example, the selector material includes Si-Ge-As-Se, As-Ge-Te-Si, or other selector material. The selector material may also include dopants such as: aluminum (Al), oxygen (O), nitrogen (N), silicon (Si), carbon (C), boron (B), zirconium (Zr), hafnium (Hf), or a combination thereof.

In some examples, the storage material is a phase change material. In other examples, the storage material can be in one or multiple stable states without a change in phase. In one example, the memory element, switching element, or both are an amorphous semiconductor threshold switch (e.g., an ovonic threshold switch) using a chalcogenide amorphous material. An ovonic threshold switch remains in an amorphous state which distinguishes it from an ovonic memory, which generally changes between amorphous and crystalline states. In one example, an ovonic memory is used in series with an ovonic threshold switch. In such case, the ovonic threshold switch operates as the select device for the ovonic memory. Whether the memory material of the memory cell changes phase or not, in one example, the memory could be referred to as a resistance-based memory. In a resistance-based memory, the bit stored by a memory cell is based on the resistive state of the memory cell.

The access lines 104, 106 electrically couple the memory cell 100 with circuitry 142. The term "coupled" can refer to elements that are physically, electrically, and/or communicatively connected either directly or indirectly, and may be used interchangeably with the term "connected" herein. Physical coupling can include direct contact. Electrical coupling includes an interface or interconnection that allows electrical flow and/or signaling between components. Communicative coupling includes connections, including wired and wireless connections, that enable components to exchange data. The access lines 104, 106 can be referred to as a bit line and word line, respectively. The word line is for accessing a particular word in a memory array and the bit line is for accessing a particular bit in the word. The access lines 104, 106 can be composed of one or more metals including: Al, Cu, Ni, Cr, Co, Ru, Rh, Pd, Ag, Pt, Au, Ir, Ta, and W; conductive metal nitrides including TiN, TaN, WN, and TaCN; conductive metal silicides including tantalum silicides, tungsten silicides, nickel silicides, cobalt silicides and titanium silicides; conductive metal silicide nitrides including TiSiN and WSiN; conductive metal carbide nitrides including TiCN and WCN, or any other suitable electrically conductive material.

In one example, electrodes 108 are disposed between storage material 102 and access lines 104, 106. Electrodes 108 electrically couple access lines 104, 106 with storage material 102. A memory cell with separate layers of storage and selector material may also include an electrode between the layers of storage and selector material. Electrodes 108 can be composed of one or more conductive and/or semiconductive materials such as, for example: carbon (C), carbon nitride (CₓN_{y}); n-doped polysilicon and p-doped polysilicon; metals including, Al, Cu, Ni, Cr, Co, Ru, Rh, Pd, Ag, Pt, Au, Ir, Ta, and W; conductive metal nitrides including TiN, TaN, WN, and TaCN; conductive metal silicides including tantalum silicides, tungsten silicides, nickel silicides, cobalt silicides and titanium silicides; conductive metal silicides nitrides including TiSiN and WSiN; conductive metal carbide nitrides including TiCN and WCN; conductive metal oxides including RuO₂, or other suitable conductive materials.

Referring again to Figure 1, the access lines 104, 106 electrically couple the memory cell 100 with circuitry 142 that accesses the memory cell 100. Circuitry for accessing memory cells (e.g., via read and write operations) is referred to generally as "access circuitry." Circuitry includes electronic components that are electrically coupled to perform analog or logic operations on received or stored information, output information, and/or store information. In one example, access circuitry can select memory cells, write to memory cells, and read from memory cells.

Writing to a memory cell involves storing a value in the memory cell by causing the storage material of the memory cell to be in a particular state. In one example, the access circuitry 143 programs the memory cell 100 by causing a voltage or current pulse with a particular polarity, magnitude, and duration through the memory cell 100. A current pulse is a rapid and transient change (e.g., increase or decrease) in current. For example, a current pulse may be defined as a rapid change from a first current level to a second current level, followed by a rapid return to the first current level. In one such example, the amplitude of the current pulse is the magnitude of the second current level relative to the first, baseline current level. Pulses can have a variety of shapes, such as rectangular, triangular, or other shapes. The width of a rectangular current pulse can be defined as the time that the current is at the transient increased or decreased level.

In one example, programming the memory cell 100 causes the memory cell 100 to "threshold" or undergo a "threshold event." In one example, when a memory cell thresholds (e.g., in response to a program pulse), the memory cell undergoes a physical change that causes the memory cell to exhibit a certain threshold voltage in response to the application of a subsequent voltage (e.g., a read voltage with a particular magnitude and polarity). Programming the memory cell 100 can therefore involve applying a voltage or current of a given polarity, magnitude, and duration to induce a programming threshold event.

In one example, reading from a memory cell involves applying a voltage pulse with a particular magnitude, polarity, and duration, which results in an electrical response from the memory cell that can be detected or sensed. Detecting electrical responses can include, for example, detecting one or more of: a voltage (e.g., a threshold voltage) across terminals of a given memory cell of the array or current through the given memory cell. In one example, detecting an electrical response involves determining that the cell's threshold voltage is lower than or higher than a reference voltage, for example a read voltage. The access circuitry 143 can determine the logic state of the memory cell 100 based on the electrical response of the memory cell to the voltage pulse.

The memory cell 100 is one example of a memory cell that can be programmed using techniques described herein. Other examples can include memory cells having additional or different layers of material than illustrated in Figure 1 (e.g., the memory cell can include a thin dielectric material between the storage material and access lines and/or other layers of material).

**Figure 2** illustrates a portion of a memory cell array 200, which can include a memory cell such as the memory cell 100 of Figure 1, in accordance with one example. The memory cell array 200 is an example of a cross-point memory array. The memory cell array 200 includes a plurality of access lines 204, 206, which can be the same or similar as the access lines 104, 106 described with respect to Figure 1. Access lines 204, 206 can be referred to as bit lines and word lines. In the example illustrated in Figure 2, the bit lines (e.g., access lines 204) are orthogonal to the word lines (e.g., access lines 206). A storage material 202 is disposed between the access lines 204, 206. In one example, a "cross-point" is formed at an intersection between a bit line, a word line. A memory cell is created from the storage material 202 between the bit line and word line where the bit line and word line intersect. The storage material 202 can be a chalcogenide material, phase change material, or both a chalcogenide material and phase change material, such as the storage material described above with respect to Figure 1. In one example, the access lines 204, 206 are composed of one or more conductive materials such as the access lines 104, 106 described above with respect to Figure 1.

Although a single level or tier of memory cells is shown in Figure 2 for the sake of clarity, memory cell array 200 typically includes multiple levels or tiers of non-volatile memory cells (e.g., in the z-direction). Nonvolatile memory devices including multiple tiers of cross-point memory cells may be referred to as three-dimensional (3D) or multi-tiered cross-point memory devices. The Figures 1 and 2 illustrate an example of a memory cell and array in which the programming techniques described herein may be implemented. However, the programming techniques described herein can be implemented in memory cell structures and arrays having different materials or structures than the examples described in Figures 1 and 2.

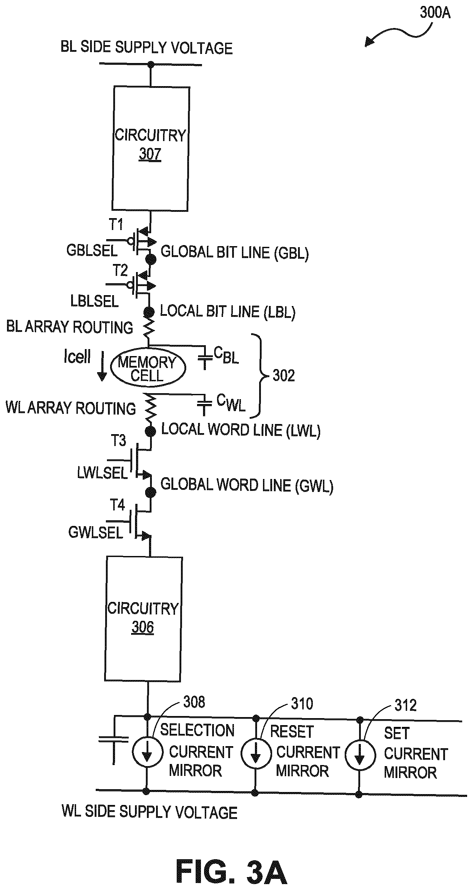

**Figure 3A** illustrates a typical circuit topology of a selected cross-point memory cell and associated decoding transistors. The circuit 300A includes a single memory cell 302. The memory cell 302 can be the same as, or similar to, the memory cell 100 of Figure 1, described above. For example, the memory cell 302 can be a cross-point and/or resistance-based memory cell. In the illustrated example, one terminal of the memory cell 302 is coupled with a bit line supply voltage and the other terminal of the memory cell 302 is coupled with a word line supply voltage. The circuit 300A also includes selection transistors (which can also be referred to as decoding transistors) between the memory cells and the supply voltages. For example, the circuit includes a global bit line selection transistor (GBLSEL) T1, a local bit line selection (LBLSEL) transistor T2, a local word line selection transistor (LWLSEL) T3, and a global word line selection transistor (GWLSEL) T4. Turning on the selection transistors T1, T2, T3, and T4 (e.g., by applying a pre-determined voltage to the gate of the transistors) selects the cell for reading or writing.

In the illustrated example, the transistors T1 and T2 are connected to the bit line side supply voltage and transistors T3 and T4 connected to the word line side supply voltage. In the illustrated example, the bit line side voltage is at the higher voltage potential than the word line side supply voltage. For example, the word line supply voltage may be negative, and the bit line supply voltage may be positive. Thus, in the illustrated example, T1 and T2 are shown as PMOS transistors and T3 and T4 are shown as NMOS transistors. The circuit 300A may include circuitry between the selection transistors and supply voltages. For example, the circuit 300A includes the circuitry 306 between the word line selection transistors and the wordline-side supply voltage. Similarly, the circuit 300A includes the circuitry 307 between the bit line selection transistors and the bit line-side supply voltage. The circuitry 306 and 307 may include, for example, a voltage regulator, circuitry to break the current path, or other circuitry supporting the control and operation of the circuit 300A. In other examples, the circuitry 306 and 307 may be omitted.

To generate the necessary current for selecting and accessing memory cells, typical memory circuit architectures include dedicated current generator circuits between the selection transistors and a voltage source. Current mirrors are one example of current generator circuits. For example, Figure 3A illustrates a circuit including selection, set, and reset current mirrors to generate the necessary current for selecting and accessing the memory cells. There is typically significant resistance and parasitic capacitance in the path from the current mirrors (or other current generator circuits) to the memory cells, which limit the edge rate that can be achieved with such dedicated current generators. Selection, setting, and resetting a memory cell typically requires different magnitudes and widths of current pulses, and therefore separate circuitry is typically used for selection, set, and reset operations. For example, the circuit in Figure 3A includes a selection current mirror 308 to generate a selection current, a reset current mirror 310 to generate a reset current pulse for resetting the memory cell, and a separate set current mirror 312 to generate a set current pulse for setting the memory cell. In the illustrated example, a program operation begins with addressing and selecting the cell via the transistors T1, T2, T3 and T4 and biasing the memory cell with a selection current. The selection current is generated with the selection current mirror 308 and is maintained active during either set or reset programming pulse. Next, for a set operation, the set current mirror 312 is enabled and the set current mirror 312 generates a set current pulse. For a reset operation, the reset current mirror 310 is enabled and the reset current mirror 310 generates a reset current pulse. The current mirrors can then be disabled until the next operation.

In one example, resetting the cell involves applying a current pulse with a large magnitude and short duration. Setting the cell involves applying a current pulse with a shorter magnitude and a longer duration. Future technology scaling may require different magnitudes and widths of programming current pulse. For example, reduced memory write time or increased memory write bandwidth may require narrower programming pulses in order to achieve energy efficient designs. Generating a short high amplitude pulse with rise time and fall time that are significantly less than the programming pulse time duration (e.g., to reset the memory cell) is more challenging than generating a longer low amplitude pulse (e.g., for setting the memory cell). The generation of a high amplitude pulse with a duration that scales with memory technology may require a sufficiently fast rise and fall time. In the example illustrated in Figure 3A, the dedicated CMOS (complementary metal oxide semiconductor) circuitry including the reset current mirror 310 shown in Figure 1 is separated from the memory cell by selection transistors and array routing. Thus, the reset current pulse generated by the reset current mirror 310 is limited by the resistance and capacitance in the path from the power supplies, which limits the rising edge time constant to reach the steady-state current target value determined by the reset current mirror. Ignoring leakage effects, the selected memory cell reset current (Icell) amplitude would equal the current driven by the reset current mirror given a sufficiently wide reset current pulse width. In the example illustrated in Figure 3A, the minimum reset current pulse width is determined primarily by the rising edge time constant of the path from the selected memory cell to the reset current mirror in the word line path. Thus, implementations with reset current mirrors are typically unable to generate sufficiently short current pulses for performing successful reset operations on cross-point memory cells. Furthermore, the wide program pulse width generated by current mirrors results in long program operation times.

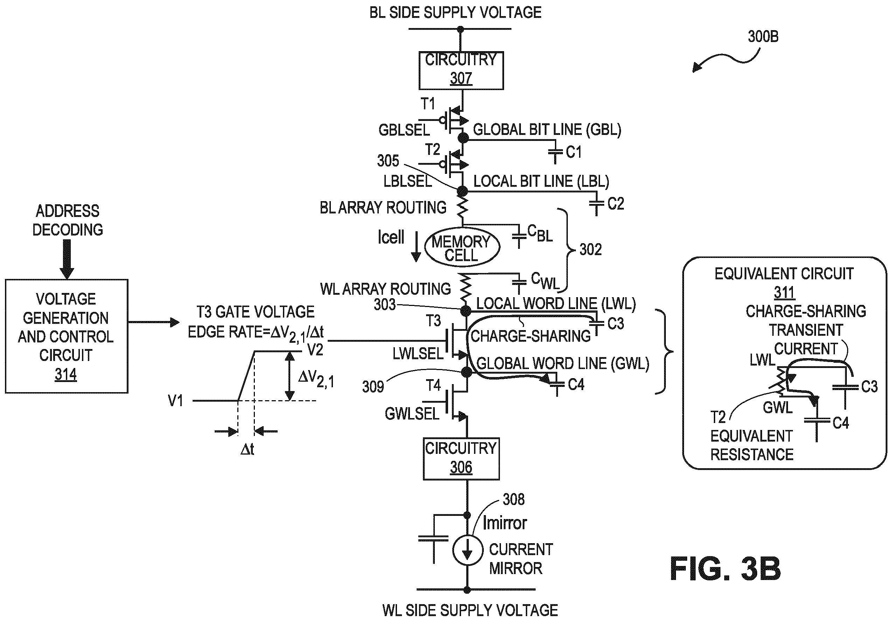

In contrast, **Figure 3B** illustrates a circuit topology of a cross-point memory cell in which a program current pulse is generated by controlling the gate voltage of a selection transistor.

Like in Figure 3A, the circuit 300B of Figure 3B includes a single memory cell 302, which can be the same as or similar to the memory cell 100 of Figure 1, described above. The memory cell 100 is coupled with selection transistors T1, T2, T3, and T4. The selection transistors T1, T2, T3, and T4 can be the same, or similar, to the transistors in the circuit 300A of Figure 3A. For example, the circuit 300B includes a global bit line selection transistor (GBLSEL) T1, a local bit line selection (LBLSEL) transistor T2, a local word line selection transistor (LWLSEL) T3, and a global word line selection transistor (GWLSEL) T4. Turning on the selection transistors T1, T2, T3, and T4 selects the cell for reading or writing.

Also like in Figure 3A, the transistors T1 and T2 are between the bit line side supply voltage and the memory cell. The transistors T3 and T4 are between the word line side supply voltage and the memory cell. In the illustrated example, the bit line side voltage is at the higher voltage potential than the word line side supply voltage. For example, the word line supply voltage may be negative, and the bit line supply voltage may be positive. Thus, in the illustrated example, T1 and T2 are shown as PMOS transistors and T3 and T4 are shown as NMOS transistors. In other examples, the word line and bit line supply voltages may be reversed (e.g., the bit line supply voltage may be negative, and the word line supply voltage may be positive) or the word line and bit line supply voltages may have the same polarity (e.g., both positive or both negative). In the example illustrated in Figure 3B, the circuit 300B includes the circuitry 306 between the word line selection transistors and the wordline-side supply voltage. Similarly, the circuit 300B includes the circuitry 307 between the bit line selection transistors and the bit line-side supply voltage. As mentioned above with respect to Figure 3A, the circuitry 306 and 307 may include, for example, a voltage regulator, circuitry to break the current path, or other circuitry supporting the control and operation of the circuit 300B. In other examples, the circuitry 306 and 307 may be omitted.

In the example illustrated in Figure 3B, the circuit 300B includes a selection current mirror 308 for generating a selection current. After the cross-point memory cell is selected, the selection current reaches a steady-state current level. As mentioned above, to perform a set or reset operation on the cell, a current pulse is generated with a magnitude that is greater than the selection current level. Unlike the circuit in Figure 3A in which the set and reset current pulses are generated with dedicated current mirrors, the circuit 300B does not include set and reset current mirrors for generating a program current pulses. Instead of using a dedicated circuit mirror, the voltage applied to the gate of a selection transistor is controlled to cause a current pulse through the memory cell 302.

For example, the circuit 300B includes voltage generation and control circuitry 314 to generate and control the voltage applied to the gate of the local word line selection transistor T3. By quickly increasing the difference in the gate voltage of the selection transistor relative to a supply voltage, the resistance of the selection transistor can be rapidly decreased. In one example, the change in resistance of the selection transistor is achieved by changing the operating point of the selection transistor from the saturation region, a high effective resistance, to the linear or triode region, a much lower effective resistance. However, the effective resistance of the selection transistor may also be changed without changing the operating point from the saturated region to linear region. The sudden decrease in resistance of the selection transistor causes a charge sharing event between capacitance at the source terminal and the drain terminal of the selection transistor. The charge sharing event causes a change in voltage across the memory cell, which in turn causes an increase in current through the memory cell. The current path through the memory cell can then be disabled to cause the current through the memory cell to decrease to zero and complete the program current pulse generation.

Consider a specific example with respect to Figure 3B in which the word line supply voltage is negative and the bit line supply voltage is positive. After selection of the memory cell 302, the gate of the local word line selection transistor T3 is at a voltage V1. The voltage V1 is typically a predetermined voltage that may be selected based on factors such as: the voltage rail polarity and magnitude (e.g., the bit line-side supply voltage and the word line-side supply voltage), the desired ΔV at the gate of T3, the characteristics of the transistor T3, the physical location of the memory cell in the array (e.g., physical location relative to array decoding circuitry), the capacitance at the source and drain terminals of T3, current bias during cell selection, and/or other factors. In one example, applying V1 to the gate of T3 results in T3 having a relatively high effective resistance.

The voltage applied to the gate of T3 by the circuit 314 is then increased from V1 to V2 over a time Δt. In one example, the circuit 314 can include a mechanism for selecting amongst one of multiple voltages (e.g., V1 and V2) to apply to the gate of the selection transistor. For example, the circuit 314 can include one or more voltage generator circuits to generate V1 and V2 and a multiplexor to select between V1 and V2. The voltage V2 is typically a second predetermined voltage that is selected based on similar factors as V1. In one example, transitioning the voltage applied to the gate of T3 causes the effective resistance of T3 to decrease. Thus, the selection transistor T3 has a higher resistance at V1 than V2. In this example, V2 is higher than V1. For example, if V1 is a negative voltage, V2 is a negative voltage with a lower magnitude, zero volts, or a positive voltage. As mentioned above, in one example, a reset current pulse is typically a current pulse with a high amplitude and short duration. In one such example, to generate a current pulse with a fast edge rate, the gate voltage edge rate of T3, which can be represented as ΔV2,1/Δt, is made as high or fast as possible. To achieve a fast gate voltage edge rate, Δt is made to be as short as possible to cause a rapid change from V1 to V2. In one example, the edge rates may be considered "fast" if the summation of the rising and falling times of the targeted programming pulse for a given address location is less than the targeted pulse time duration. In one example, Δt is shorter than the time constant of the path. Therefore, in some examples, the voltage generation and control circuit is implemented to quickly transition the gate voltage of the selection transistor.

In addition to controlling the gate voltage to achieve particular current pulse edge rates, the amplitude of the program current pulse can be determined by adjusting the voltages V1 and V2. In one example, the amplitude of the program pulse is measured or defined relative to the steady-state selection current amplitude that is required to maintain selection of the memory cell. In one example, the amplitude of the program current pulse is based in part on the difference between V1 and V2 (ΔV2,1). A large voltage difference between V1 and V2 results in a relatively high magnitude current pulse and a lower voltage difference between V1 and V2 results in a lower magnitude current pulse. As mentioned above, the desired amplitude of the current pulse will vary depending on factors such as whether the program operation is a set or reset operation and further based on the memory cell's location in the array. In one example, the voltage V2 is the same for memory cells in different locations in the array, and the voltage V1 is varied based on memory cell location (e.g., distance from decoding circuitry). In another example, the voltage V1 is the same for memory cells in different locations in the array, and the voltage V2 is varied based on memory cell location. Alternatively, both V1 and V2 can be varied based on memory cell location.

The increase in voltage at the gate of T3 causes the resistance of T3 to decrease, which in turn causes current to flow from C3 (the local word line capacitance at the source terminal of T3) to C4 (the global word line capacitance at the drain terminal of T3) due to charge sharing between C3 and C4. Thus, in the illustrated example, the local word line selection transistor (T3) behaves as a voltage controlled resistance where its effective resistance primarily depends on the gate-to-source voltage of the T3, as is shown in the equivalent circuit 311. As can be seen in the equivalent circuit 311, C3 and C4 are separated by the voltage controlled resistance formed by the selection transistor T3. The increase in the gate voltage of the local word line selection transistor (T3) results in an increase in its gate-to-source voltage that in turn reduces the effective resistance of the local word line transistor (T3), thus controlling the discharge rate from capacitance C3 to capacitance C4. As the charge-sharing event occurs, the local word line voltage at node 303 decreases due to the discharge of the charge associated with the word line capacitance (C3) to the global word line capacitance (C4). As result of this charge-sharing, the global word line voltage at node 309 increases. The rapid decrease of the word line voltage level initiated by the charge-sharing event involving the capacitances of the local and global word lines creates an increased voltage differential across the memory cell from its local bit line to the local word line voltage with an edge rate that is proportional to the ΔV/Δt of the gate voltage of T3.

In one example, the capacitances C3 and C4 are the parasitic capacitances of the conductive interconnects (e.g., wires, traces, or other conductive interconnects). Thus, in one example, the capacitance C3 and C4 are implicit capacitances in the routing and not physical capacitor devices. The charge-sharing transient current from C3 to C4 results in a decrease in voltage at the local word line (node 303). The decrease in voltage at the local word line creates a voltage differential across the memory cell 302 (e.g., the voltage at the local bit line at node 305 minus the voltage at the local word line at node 303 increases). The voltage differential across the memory cell results in an increase in the current through the memory cell (Icell). In increase in current is the start of or rising edge of the program current pulse. The current path through the memory cell is then disabled (e.g., by opening a switch in the circuit, such as a switch in circuitry 306, to stop the flow of current from the bit line side supply voltage to the word line side supply voltage). The decrease in current is the termination of or falling edge of the program current pulse. The current pulse width can thus be controlled via timing of the signals used to initiate and terminate the current pulse.

The above example considers an implementation in which the program current pulse is generated by controlling the voltage applied to a selection transistor on the word line-side (e.g., between the memory cell and the word line side supply voltage). A program current pulse can also be generated by controlling the voltage applied to a selection transistor on the bit line side in addition to, or instead of, controlling the gate voltage of a selection transistor on the word line side.

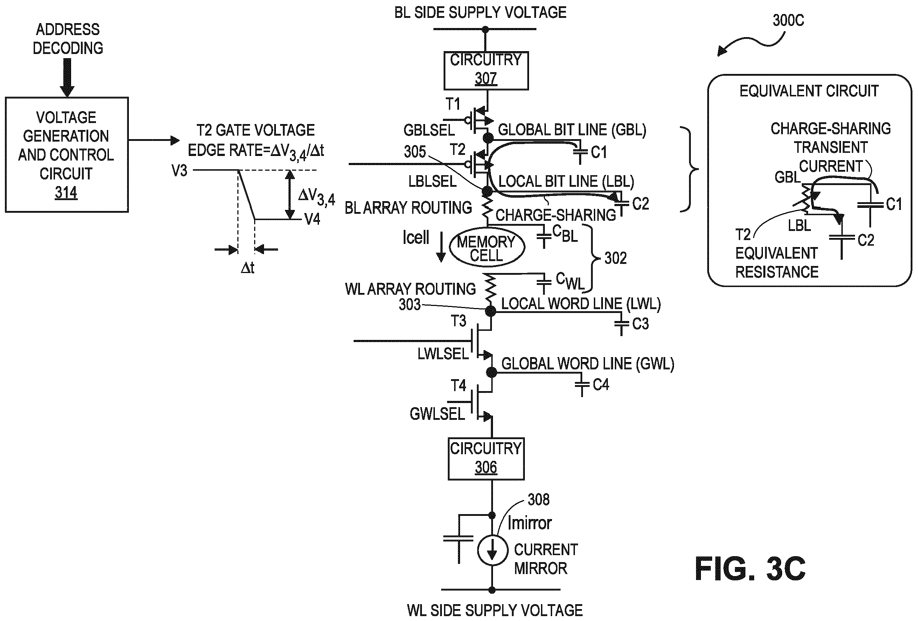

**Figure 3C** illustrates a circuit topology of a cross-point memory cell in which a program current pulse is generated by controlling the gate voltage of a selection transistor on the bit line side. The circuit 300C illustrated in Figure 3C is identical to the circuit 300B in Figure 3B except that the voltage generation and control circuit 314 controls the voltage applied to the gate of the local bit line selection transistor T2 instead of T3 to generate a program current pulse.

Consider an example with respect to Figure 3C in which the bit line side supply voltage is greater than the word line side supply voltage. After selection of the memory cell 302, the gate of the local word line selection transistor T2 is at a voltage V3. The voltage V3 is typically a predetermined voltage that may be selected based on similar factors as V1 and V2, discussed above.

The voltage applied to the gate of T2 is then decreased from V3 to V4 over a time Δt. The voltage V4 is typically a second predetermined voltage that is selected based on similar factors V1 and V2, discussed above. In this example, V4 is lower than V3. For example, if V3 is a positive voltage, V4 is a positive voltage with a lower magnitude than V3, zero volts, or a negative voltage. As mentioned above, in one example, Δt is made as short as possible to cause a rapid change from V3 to V4, and thus a current pulse with a square edge. The Δt over which the gate voltage of T2 is transitioned from V3 to V4 may be the same as or different than the Δt of Figure 3B.

The increase in voltage at the gate of T2 causes the resistance of T2 to decrease, which in turn causes current to flow from C1 (the global bit line capacitance at the source terminal of T2) to C2 (the local bit line capacitance at the drain terminal of T2) due to charge sharing between C1 and C2. Like the capacitances C3 and C4 discussed above with respect to Figure 3B, the capacitances C1 and C2 may be implicit capacitances of the conductive interconnects. The charge-sharing transient current from C1 to C2 results in an increase in voltage at the local bit line (node 305). The increase in voltage at the local bit line creates a voltage differential across the memory cell 302 (e.g., the voltage at the local bit line at node 305 minus the voltage at the local word line at node 303 is increased). The voltage differential across the memory cell results in an increase in the current through the memory cell (Icell). The current path through the memory cell is then disabled (e.g., by opening a switch in the circuit, such as circuitry 307, to stop the flow of current from the bit line side supply voltage to the word line side supply voltage). Thus, the gate voltage of a selection transistor on the bit line side may also be controlled to generate a program current pulse through the memory cell.

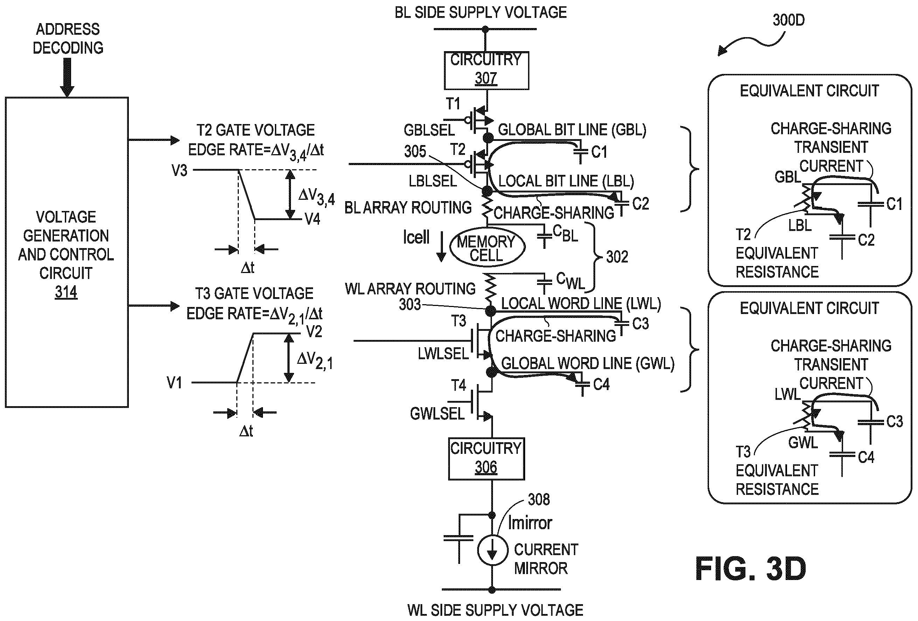

**Figure 3D** illustrates an example in which the gate voltage of selection transistors on both the word line and bit line sides are controlled to generate a program current pulse. The circuit 300D is the same as, or similar to, the circuits 300B and 300C, discussed above. In the example illustrated in Figure 3D, the voltage generation and control circuit 314 applies a voltage V1 to the gate of the local word line selection transistor T3 and a voltage V3 to the gate of the local bit line selection transistor T2. The voltage generation and control circuit 314 then transitions the voltage applied to the gates of T2 and T3 to create a voltage increase across the memory cell 302. In one example, the gate voltage of T2 and the gate voltage of T3 are changed simultaneously. In the illustrated example, the voltage applied to the gate of T2 is decreased and the voltage applied to the gate of T3 is increased, resulting in a change in voltage at both nodes 303 and 305. In one example, by changing the gate voltage of selection transistors on either side of the memory cell, a larger voltage differential across the memory cell can be achieved than by changing the gate voltage of a selection transistor on only one side of the memory cell. For example, the local bit line voltage is increased at the same time the local word line is decreased, resulting in a larger voltage difference across the memory cell. Like in the examples of Figures 3B and 3C, the voltage difference across the memory cell causes an increase in current, and the current can then be decreased to generate the program current pulse.

The above examples discussed with respect to Figures 3B-3D consider implementations in which the word line-side supply voltage is less than the bit line-side supply voltage; however, the same technique to generate a program current pulse can be used for supply rails of any polarity and magnitude. In one example, regardless of the polarity of the supply voltage coupled with the selection transistor(s) used for generating the program current pulse, the gate voltage is transitioned from a first voltage to a second voltage to increase the voltage difference between the gate and the supply voltage. Thus, in one example, if the selection transistor is between a positive supply voltage and the memory cell, the gate voltage of the selection transistor is decreased to generate the program current pulse. If the selection transistor is between a negative supply voltage and the memory cell, the gate voltage of the selection transistor is increased to generate the program current pulse. Regardless of the voltage rail polarities, in one example, the gate voltage of the selection transistor is changed to generate a modulation or substantial change in effective resistance of the transistor, typically the local selection transistor, connected between the capacitances.

The above examples discuss implementations in which the capacitors C1, C2, C3, and C4 are implicit capacitances in the routing rather than discrete capacitors. However, other examples may include physical capacitors to tune the capacitance at the nodes between the memory cell and the selection transistors. The capacitances C1, C2, C3, and C4 could also be adjusted by other means, such as including additional wire routing or adjusting the number of word line selects coupled with a global word line select. Adjusting the capacitance can affect the magnitude of the program current pulse. However, including physical capacitors has the downside of increasing die size.

Also note that although the examples illustrated in Figures 3B-3D show the gate voltage of local selection transistors being controlled to generate the program current pulse, other examples could control the gate voltage of other selection transistors (e.g., the global selection transistors) to generate the program current pulse.

The examples illustrated in Figures 3B-3D show the bit line-side selection transistors as PMOS transistors and the word line-side selection transistors as NMOS transistors to correspond to the word line-side supply voltage being negative and the bit line-side supply voltage being positive in reference to VSS; however, as mentioned above, it is possible to make the word line-side supply voltage connect to VSS and the bit line-side supply voltage be a positive voltage. In one such example, V1, V2, V3, and V4 would be positive and may or may not have the same transition polarity. Similarly, it is possible to make the word line-side supply voltage connect to some negative supply level and the bit line-side supply voltage be connected to VSS; in one such example, V1, V2, V3, and V4 would be negative and may or may not be the same transition polarity.

Also note that although the examples illustrated in Figures 3B-3D are shown as not including current mirrors for generating set and reset currents, other examples may include a set current mirror, or a reset current mirror. For example, the technique described above may be used to generate reset current pulses, while a current mirror is used to generate set current pulses.

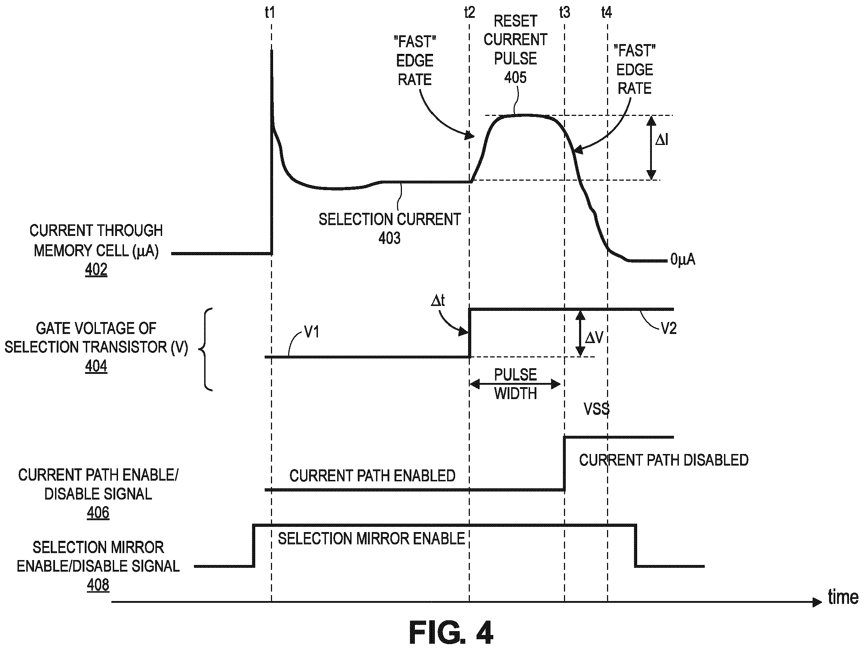

**Figure 4** is an example of a reset operation waveform of a selected memory cell. The waveform 402 illustrates the current through a cross point memory cell (e.g., the such as the memory cell 100 of Figure 1) versus time. The waveforms 404, 406, and 408 illustrate control signals for generating the current pulse through the memory cell shown in the waveform 402. Specifically, the waveform 404 illustrates an example of the gate voltage of a selection transistor (e.g., the gate voltage of T3 of Figure 3B) versus time. The waveform 406 illustrates an example of a current path enable/disable signal versus time. The waveform 408 illustrates an example of a selection mirror enable/disable signal versus time.

Referring to the waveform 402, at time t1, the memory cell is selected. To select the memory cell, the selection current mirror is enabled (as is shown in the waveform 408 at time t1) and the selection transistors are on. The example illustrated in Figure 4 shows a current spike upon memory cell selection, however, a selection current spike may or may not be present upon cell selection. After the memory cell is selected, the selection current reaches a steady-state current level 403. At time t1, the gate voltage of the selection transistor is V1, as is shown in the waveform 404. At time t2, the gate voltage of the selection transistor is transitioned from V1 to a higher voltage V2 over a time increment Δt. The transition from V1 to V2 at the gate of the selection transistor triggers the reset current pulse 405. The time increment Δt is made small to cause a fast rising edge rate of the current pulse 405.

At time t3, the reset current pulse is terminated by "breaking" the current flow from the bit line to the word line side of the memory cell, as shown by the current path enable/disable signal 406. The overall reset current pulse width for performing the reset operation can be controlled by the current path enable signal 406. For example, the current path can be disabled at or immediately after time t2 to generate a short current pulse. The current path can be disabled after a longer time (e.g., t3 or later) to generate a longer current pulse. After disabling the current path, the current through the memory cell goes to 0 µA at time t4. After the set or reset operation is complete, the selection mirror enable/disable signal 408 can be transitioned low (disabled) to reduce power, as is shown in Figure 4. Alternatively, the selection mirror enable/disable signal 408 can remain high (enabled). Thus, the gate voltage of a selection transistor can be controlled to generate reset current pulse for performing a reset operation on a cross-point non-volatile memory cell.

The voltage level V1 can be adjusted, as well as its rate of transition to voltage V2, to form the control of the charge-sharing event that results in the current pulse. The voltage differential produced (V2 - V1) determines the amplitude of the reset current pulse or maximum current level delivered to the cross-point memory cell. In addition, the selection current level (e.g., the selection current 403) can also be adjusted (e.g., either increasing or decreasing in current magnitude) to adjust the reset current pulse amplitude or maximum value. The control of the selection current can be in addition to, or independent of the control of ΔV/Δt of the selection transistor gate voltage to control the reset current pulse amplitude. These mechanisms for adjusting the reset current pulse maximum value can be used to adjust the current pulse for cross-point memory cells that are located at various physical addresses in the memory array.

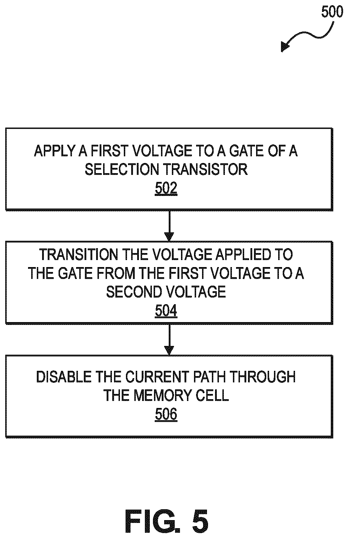

**Figure 5** is a flow chart of an example of a method for generating a program current pulse in a cross-point memory cell. The method 500 of Figure 5 can be performed by logic in the memory device. The logic can include hardware circuitry, software or firmware (e.g., microcode stored on the memory device), or a combination of hardware, software, and firmware.

The method 500 begins with applying a first voltage to a gate of a selection transistor, at operation 502. For example, referring to Figure 3B, the voltage generation and control circuit 314 applies a first voltage V1 to the gate of the local word line selection transistor. In another example, the circuit 314 applies a first voltage V3 to the gate of the local bit line selection transistor. In another example, initial voltages may be applied to the gates of selection transistors on both the bit line and word line sides (e.g., referring to Figure 3D, V1 may be applied to T3 and V3 applied to T2).

After applying the first voltage to the gate of the selection transistor, the voltage applied to the gate is then transitioned from the first voltage to a second voltage, at operation 504. For example, referring to Figure 3B, the circuit 314 transitions the voltage applied to the gate of T3 from V1 to V2. In another example, referring to Figure 3B, the circuit 314 transitions the voltage applied to the gate of T2 from V3 to V4. In an example in which the gates of selection transistors on both the bit line and word line sides are being controlled to generate the current pulse, the method involves simultaneously transitioning the voltage applied to the gate of the bit line selection transistor and the voltage applied to the gate of the word line selection transistor to subsequent voltages. For example, referring to Figure 3D, the voltage applied to the gate of T2 is transitioned to V4 at the same time the voltage applied to the gate of T3 is transitioned to V2. Regardless of which selection transistor is used, the voltage difference between the supply voltage and the second voltage is greater than the voltage difference between the supply voltage and the first voltage. Therefore, transitioning from the first voltage to the second voltage increases the voltage difference between the gate of the selection transistor and the supply voltage. As described above, the transition from the first voltage to the second voltage results in a voltage increase across the memory cell, which in turn causes an increase in current through the memory cell.

After transitioning the voltage applied to the gate of the selection transistor to cause an increase in current, the method involves disabling the current path through the memory cell, at operation 506. Disabling the current path can involve any technique for stopping the flow of current such as with a switch along the current path. The timing of disabling the current path enables control of the current pulse width. In one example, the current path can be disabled at the same time as, or very shortly after, transitioning the voltage from the first to the second voltage to generate a very narrow current pulse.

Thus, a program current pulse (such as a reset or set pulse) can be generated and controlled with improved efficiency and effectiveness compared to conventional techniques. Generating a program current pulse from a charge-sharing rather than dedicated CMOS circuitry such as a reset and set current mirrors can result in narrower current pulses with faster edge rates in addition to reducing energy usage and die size.

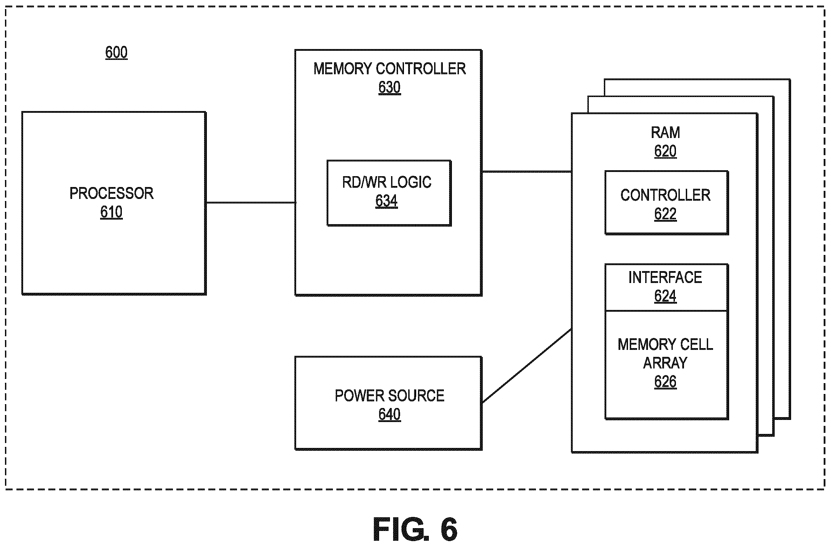

**Figure 6** is a block diagram of a system that can include a non-volatile memory device in accordance with examples described herein.

System 600 includes components of a memory subsystem having random access memory (RAM) 620 to store and provide data in response to operations of processor 610. The system 600 receives memory access requests from a host or a processor 610, which is processing logic that executes operations based on data stored in RAM 620 or generates data to store in RAM 620. The processor 610 can be or include a host processor, central processing unit (CPU), microcontroller or microprocessor, graphics processor, peripheral processor, application specific processor, or other processor, and can be single core or multicore.

The system 600 includes a memory controller 630, which represents logic to interface with RAM 620 and manage access to data stored in the memory. In one example, the memory controller 630 is integrated into the hardware of processor 610. In one example, the memory controller 630 is standalone hardware, separate from the processor 610. The memory controller 630 can be a separate circuit on a substrate that includes the processor. The memory controller 630 can be a separate die or chip integrated on a common substrate with a processor die (e.g., as a system on a chip (SoC)). In one example, the memory controller 630 is an integrated memory controller (iMC) integrated as a circuit on the processor die. In one example, at least some of RAM 620 can be included on an SoC with the memory controller 630 and/or the processor 610.

In the illustrated example, the memory controller 630 includes read/write logic 634, which includes hardware to interface with the RAM 620. The logic 634 enables the memory controller 630 to generate read and write commands to service requests for data access generated by the execution of instructions by processor 610.

The memory resources or cachelines in the RAM 620 are represented by a memory cell array 626, which can include a 3D cross-point array. The RAM 620 includes an interface 624 (e.g., interface logic) to control the access to the memory device array 626. The interface 624 can include decode logic, including logic to address specific rows or columns, bit lines or word lines, or otherwise address specific bits of data. The controller 622 represents an on-die controller on RAM 620 to control its internal operations to execute commands received from memory controller 630. For example, the controller 622 can control any of timing, voltage levels, addressing, I/O (input/output) margining, scheduling, and error correction for RAM 620.

In one example, the controller 622 is configured to read and write to the memory device array 626 (e.g., via set and reset operations) in accordance with any example described herein. A power source 640 is connected to the RAM 620 to provide one or more voltage rails for operation of the RAM 620.

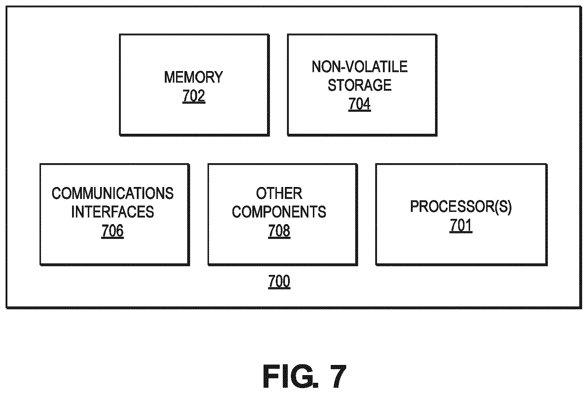

**Figure 7** provides an exemplary depiction of a computing system 700 (e.g., a smartphone, a tablet computer, a laptop computer, a desktop computer, a server computer, etc.). As observed in Figure 7, the system 700 may include one or more processors or processing units 701. The processor(s) 701 may include one or more central processing units (CPUs), each of which may include, e.g., a plurality of general-purpose processing cores. The processor(s) 701 may also or alternatively include one or more graphics processing units (GPUs) or other processing units. The processor(s) 701 may include memory management logic (e.g., a memory controller) and I/O control logic. The processor(s) 701 can be similar to, or the same as, the processor 610 of Figure 6.

The system 700 also includes memory 702 (e.g., system memory), non-volatile storage 704, communications interfaces 706, and other components 708. The other components may include, for example, a display (e.g., touchscreen, flat-panel), a power supply (e.g., a battery or/or other power supply), sensors, power management logic, or other components. The communications interfaces 706 may include logic and/or features to support a communication interface. For these examples, communications interface 706 may include one or more communication interfaces that operate according to various communication protocols or standards to communicate over direct or network communication links or channels. Direct communications may occur via use of communication protocols or standards described in one or more industry standards (including progenies and variants) such as those associated with the PCIe specification. Network communications may occur via use of communication protocols or standards such those described in one or more Ethernet standards promulgated by IEEE. For example, one such Ethernet standard may include IEEE 802.3. Network communication may also occur according to one or more OpenFlow specifications such as the OpenFlow Switch Specification. Other examples of communications interfaces include, for example, a local wired point-to-point link (e.g., USB) interface, a wireless local area network (e.g., WiFi) interface, a wireless point-to-point link (e.g., Bluetooth) interface, a Global Positioning System interface, and/or other interfaces.

The computing system also includes non-volatile storage 704, which may be the mass storage component of the system. The non-volatile storage 704 can be similar to, or the same as, the RAM 620 of Figure 6, described above. Non-volatile storage 704 may include byte or block addressable types of non-volatile memory having a three-dimensional (3D) cross-point memory structure hereinafter referred to as "3D cross-point memory". Non-volatile types of memory may also include other types of byte or block addressable non-volatile memory such as, but not limited to, multi-threshold level NAND flash memory (e.g., 3D NAND flash memory), NOR flash memory, single or multi-level phase change memory (PCM), resistive memory, nanowire memory, ferroelectric transistor random access memory (FeTRAM), magnetoresistive random access memory (MRAM) that incorporates memristor technology, spin transfer torque MRAM (STT-MRAM), or a combination of any of the above. In one example, the non-volatile storage 704 may include mass storage that is composed of one or more SSDs (solid state drives), DIMMs (dual in line memory modules), or other module or drive. The non-volatile storage 704 may implement techniques for generating program current pulses in accordance with examples described herein.

Various components described herein can be a means for performing the operations or functions described. Each component described herein includes software, hardware, or a combination of these. The components can be implemented as software modules, hardware modules, special-purpose hardware (e.g., application specific hardware, application specific integrated circuits (ASICs), digital signal processors (DSPs), etc.), embedded controllers, hardwired circuitry, etc.

Besides what is described herein, various modifications can be made to the disclosed embodiments and implementations of the invention without departing from their scope. Therefore, the illustrations and examples herein should be construed in an illustrative, and not a restrictive sense. The scope of the invention should be measured solely by reference to the claims that follow.

## Claims

1. A circuit comprising:
a non-volatile memory cell;
a selection transistor between the non-volatile memory cell and a first supply voltage; and circuitry to cause a program current pulse through the non-volatile memory cell, including to:
apply a first voltage to a gate of the selection transistor,
transition the first voltage applied to the gate of the selection transistor to a second voltage, and
disable a current path through the non-volatile memory cell.

2. The circuit of claim 1, wherein the circuitry to transition the first voltage applied to the gate to the second voltage is to:
increase the voltage difference between the gate voltage of the selection transistor and the first supply voltage.

3. The circuit of claim 1, wherein:
the transition from the first voltage to the second voltage is to cause a change in voltage at a node between the selection transistor and the memory cell.

4. The circuit of claim 1, wherein:
the transition from the first voltage to the second voltage is to cause an increase in current through the memory cell.

5. The circuit of claim 4, wherein:
the increase in current comprises a rising edge of a reset or set current pulse.

6. The circuit of claim 5, wherein:
the disabling of the current path is to cause a falling edge of the reset or set current pulse.

7. The circuit of claim 1, wherein:
the selection transistor comprises a word line selection transistor to select the memory cell.

8. The circuit of claim 1, wherein:
the selection transistor comprises a bit line selection transistor to select the memory cell.

9. The circuit of claim 1, wherein:
the selection transistor is to have a higher resistance at the first voltage than at the second voltage.

10. The circuit of claim 1, wherein:
the transition from the first voltage to the second voltage is to enable a charge-sharing current to flow from a capacitance at one terminal of the transistor to a second terminal of the transistor.

11. The circuit of claim 1, wherein:
the second voltage is ground; and
the magnitude of the first voltage is greater than ground and less than or equal to the magnitude of the supply voltage.

12. The circuit of claim 1, wherein the circuitry to disable the current path is to:
after the transition of the gate of the selection transistor from the first voltage to the second voltage, transition an enable/disable signal to a value to open a switch between the non-volatile memory cell and the first supply voltage, a second supply voltage, or ground.

13. The circuit of claim 1, wherein:
wherein the circuitry to cause a program current pulse through the non-volatile memory cell is to:
simultaneously transition a voltage applied to a gate of a bit line selection transistor and a voltage applied to a gate of a word line selection transistor to subsequent voltages to generate the program current pulse.

14. The circuit of claim 1, wherein:
the non-volatile memory cell comprises a cross-point memory cell.

15. The circuit of claim 1, wherein:
the non-volatile memory cell comprises a chalcogenide material.
